# EUROPEAN PATENT APPLICATION

(11) **EP 4 832 694 A1**
(43) Date of publication of application: **28.10.2026**
(21) Application number: 26172173.2
(22) Date of filing: 14.04.2026
(51) Int. Cl.: H10F 19/90, H10F 77/00, H10F 77/42

(54) **COMBINER STRUCTURE, PHOTOVOLTAIC MODULE AND MANUFACTURING METHOD THEREFOR**

(30) Priority: 27.04.2025 CN 202510537887
(71) Applicant: Tongwei Solar (Chengdu) Co., Ltd., Chengdu, Sichuan 610299 (CN)
(72) Inventor: ZHENG, Yijie, Chengdu 610299 (CN); ZHAO, Liyan, Chengdu 610299 (CN); TAN, Xiaochun, Chengdu 610299 (CN)
(74) Representative: Murgitroyd & Company

(57) **Abstract**

Disclosed are a combiner structure, a photovoltaic module, and a manufacturing method therefor. The combiner structure is disposed between two adjacent cell strings in the photovoltaic module. The combiner structure includes: an adhesive layer, adhered to a backsheet of the photovoltaic module; a conductive layer, provided on the adhesive layer, electrically connected to bus bars of two adjacent cell strings; and a reflective layer, provided on the conductive layer, used to reflect light incident on the combiner structure. Thus, the combiner structure is fixed to the backsheet of the photovoltaic module through the adhesive layer eliminating the need for an additional insulation process for the combiner structure, thereby reducing complexity and lowering production cost. Moreover, through the electrical connection between the conductive layer and the two adjacent cell strings, the shading on the cell strings is reduced, avoiding occupation of an internal space by the combiner structure.

## Description

### TECHNICAL FIELD

The present disclosure relates to the field of solar cell technologies, and in particular, to a combiner structure, a photovoltaic module and a manufacturing method therefor.

### BACKGROUND

Photovoltaic power generation, as a green energy solution to replace fossil fuels, is now being used more and more widely. A photovoltaic solar cell is a device that converts light energy into electrical energy. Specifically, the solar cell utilizes the photovoltaic effect to generate charge carriers, which are then extracted via electrodes to facilitate effective utilization of electrical energy. Currently, conventional photovoltaic modules employ a series-parallel configuration and use a three-part junction box to draw out the circuit while also serving a bypass function.

The photovoltaic modules are divided into single-glass and double-glass modules. For the double-glass modules, power output can be increased by applying a gap film to the back glass. For some modules with special functions or designed for specific application scenarios, interconnecting ribbons are required between cell strings to form electrical circuits. Currently, in conventional technologies, the cell strings are connected through bus bars. However, this method occupies space of the battery, reducing a light-receiving area of the battery cell, thereby affecting efficiency of the photovoltaic module. Additionally, the bus bars require isolation and insulation, making the process relatively complex and increasing the overall module cost.

### SUMMARY

In view of above, it is necessary to provide a combiner structure, a photovoltaic module and a manufacturing method therefor to address problems of reduced light-receiving area of battery cells and low light utilization efficiency caused by current use of the bus bars to connect two cell strings, which can ensure the light-receiving area, increase the efficiency of the photovoltaic module, and improve light utilization efficiency.

Embodiments of the present disclosure provide a combiner structure disposed between two adjacent cell strings in a photovoltaic module. The combiner structure includes:
an adhesive layer, adhered and fixed to a backsheet of the photovoltaic module;
a conductive layer, disposed on the adhesive layer and electrically connected to bus bars of the two adjacent cell strings; and
a reflective layer, disposed on the conductive layer and used for reflecting light incident on the combiner structure.

In an embodiment of the present disclosure, the reflective layer includes a plurality of projections having inclined surfaces. The plurality of projections are arranged sequentially along a first direction of the combiner structure, and the projections are used for reflecting the light.

In an embodiment of the present disclosure, a shape of one of the plurality of projections is any one of a two-sided pyramid, a three-sided pyramid, a four-sided pyramid and a cone.

In an embodiment of the present disclosure, the reflective layer is made of a conductive material, and the reflective layer is welded to the bus bars of the two adjacent cell strings.

In an embodiment of the present disclosure, the reflective layer is made of a non-conductive material. The reflective layer is provided with a preset welding area corresponding to the bus bars of the cell strings, and the preset welding area is configured to expose the conductive layer, enabling the conductive layer to be electrically connected to the bus bars through the preset welding area.

In an embodiment of the present disclosure, the conductive layer is made of a conductive material or a superconducting material.

In an embodiment of the present disclosure, the adhesive layer is physically bonded to the backsheet by glue, or the adhesive layer is bonded to the backsheet by silica gel.

In an embodiment of the present disclosure, the reflective layer is made of any one of an aluminum material, a polyethylene terephthalate reflective film, and a reflective coating.

In an embodiment of the present disclosure, the reflective layer is connected to the conductive layer by adhesive bonding, heating, or coating; and/or
the conductive layer is made of copper, silver, gold, titanium, niobium, tin, or bismuth.

In an embodiment of the present disclosure, a width of the combiner structure in a second direction ranges from 2 mm to 12 mm; and/or
a thickness of the combiner structure in a third direction ranges from 0.1 mm to 0.5 mm.

Embodiments of the present disclosure further provide a photovoltaic module, including: a cover glass, a backsheet, a plurality of cell strings, a front adhesive film, a back adhesive film, and a plurality of combiner structure as described in any one of the above technical features;
the cover glass is disposed above the backsheet, and the plurality of cell strings extend along a first direction and are spaced apart along a second direction between the cover glass and the backsheet;
the front adhesive film is disposed between the cover glass and the plurality of cell strings, and the back adhesive film is disposed between the plurality of cell strings and the backsheet; and
the combiner structure is disposed between the back adhesive film and the backsheet and extends along the first direction, and the combiner structure is disposed between two adjacent cell strings and electrically connects bus bars of the two adjacent cell strings.

In an embodiment of the present disclosure, the bus bar of each of the plurality of cell strings includes a first bus bar and a second bus bar with opposite polarities; and
the combiner structure is electrically connected to the first bus bar of a preceding cell string and the second bus bar of a next cell string to make adjacent cell strings connected in series.

In an embodiment of the present disclosure, the bus bar of each of the plurality of cell strings includes a first bus bar and a second bus bar with opposite polarities; and
the first bus bars of the two adjacent cell strings are connected and the second bus bars of the two adjacent cell strings are connected, so that the two adjacent cell strings are connected in parallel; and the photovoltaic module further includes a junction box, configured to connect the first bus bars of the plurality of cell strings in series and the second bus bars of the plurality of cell strings in series, so that the first bus bars and the second bus bars are connected by the combiner structure to allow the two adjacent cell strings to be short-circuited under a preset condition.

In an embodiment of the present disclosure, the back adhesive film is provided with a hollow area corresponding to the bus bar of one of the plurality of cell strings, and the combiner structure is electrically connected to the bus bar through the hollow area; and/or
a material of the backsheet is composite plate or backsheet glass.

Embodiments of the present disclosure further provide a manufacturing method for a photovoltaic module, which is used for manufacturing the photovoltaic module as described in any one of the above technical features. The method includes the following steps:
laying a front adhesive film on a cover glass;
laying a plurality of cell strings on the front adhesive film;
welding a bus bar to an edge of one of the plurality of cell strings;
laying a back adhesive film on a surface, facing away from the front adhesive film, of the plurality of cell strings;
providing a combiner structure on the back adhesive film, and welding the combiner structure to the bus bars of two adjacent cell strings; and
providing a backsheet to cover the combiner structure and performing component lamination.

The present disclosure has at least the following technical effects by adopting the above technical solutions.

According to the combiner structure, the photovoltaic module and the manufacturing method therefor provided by the present disclosure, the combiner structure is provided in a gap between two adjacent cell strings within the photovoltaic module, and the combiner structure is fixed to the backsheet of the photovoltaic module by the adhesive layer. The conductive layer is provided on the adhesive layer, and the reflective layer is provided on the conductive layer. The combiner structure is electrically connected to the two adjacent cell strings through the conductive layer to realize the connection between the two adjacent cell strings. Meanwhile, the combiner structure can reflect the light incident in the gap between the two adjacent cell strings through the reflective layer.

In the combiner structure, the conductive layer is provided on the adhesive layer, and the reflective layer is provided on the conductive layer, so that the combiner structure is fixed to the backsheet of the photovoltaic module through the adhesive layer, thereby fixing the combiner structure between the two adjacent cell strings reliably without insulating the combiner structure, reducing manufacturing complexity, and reducing the costs. Moreover, the combiner structure is arranged in the gap of two adjacent cell strings of the photovoltaic module, and the two adjacent cell strings are electrically connected by the conductive layer. Thus, a shielded area of the cell strings is reduced, and the combiner structure is avoided from occupying the space inside the photovoltaic module, thereby improving efficiency of the module. Meanwhile, the light is reflected in the gap of the two adjacent cell strings by the reflective layer, so as to improve the light utilization efficiency, which further improve the efficiency of the photovoltaic module.

### BRIEF DESCRIPTION OF THE DRAWINGS

FIG. 1 is a schematic diagram of a combiner structure according to an embodiment of the present disclosure.
FIG. 2 is a schematic diagram of an embodiment of connecting two cell strings by the combiner structure shown in FIG. 1.
FIG. 3 is a schematic diagram of another embodiment of connecting two cell strings by the combiner structure shown in FIG. 1.
FIG. 4 is a schematic diagram of light reflection by the combiner structure shown in FIG. 1.
FIG. 5 is a schematic diagram of an embodiment of connection between the combiner structure shown in FIG. 1 and a cell string.
FIG. 6 is a schematic diagram of another embodiment of connection between the combiner structure shown in FIG. 1 and a cell string.
FIG. 7 is a partial enlarged view of connection between the combiner structure shown in FIG. 2 and a cell string at A.
FIG. 8 is a flowchart of manufacturing processes for a photovoltaic module according to an embodiment of the present disclosure.

### Reference Numerals

10, photovoltaic module; 100, combiner structure; 110, adhesive layer; 120, conductive layer; 130, reflective layer; 131, projection; 132, preset welding area; 200, cell string; 210, bus bar; 211, first bus bar; 212, second bus bar; 300, cover glass; 400, back adhesive film; 410, hollow area; 350, front adhesive film; 500, backsheet.

### DETAILED DESCRIPTION OF THE EMBODIMENTS

To make the above objects, features, and advantages of the present disclosure more apparent and easier to understand, the following describes the specific embodiments of the present disclosure in detail with reference to accompanying drawings. In the following description, many specific details are set forth to facilitate a full understanding of the present disclosure. However, the present disclosure can be implemented in many other ways different from those described herein. Those skilled in the art can make similar improvements without departing from the present disclosure. Therefore, the present disclosure is not limited by the specific embodiments disclosed below.

In the description of the present disclosure, it should be understood that terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential" indicate orientations or positional relationships based on the orientations or positional relationships shown in the accompanying drawings. They are only for the convenience of describing the present disclosure and simplifying the description, and do not indicate or imply that the referred device or element must have a specific orientation or be constructed and operated in a specific orientation. Therefore, they should not be construed as limiting the present disclosure.

In addition, if these terms "first" and "second" appear, they are only used for descriptive purposes and cannot be understood as indicating or implying relative importance or implying the number of technical features indicated. Therefore, the features that are limited to "first" and "second" can explicitly or implicitly include at least one of these features. In the description of the present disclosure, if the term "a plurality of' appears, the meaning of "a plurality of' is at least two, such as two, three, etc., unless otherwise specified.

In the present disclosure, unless otherwise explicitly specified and defined, terms such as "install", "connect", "link", "fix" should be interpreted broadly. For example, they may refer to fixed connections, detachable connections, or integrated connections; they may refer to mechanical connections or electrical connections; they may refer to direct connections or indirect connections through an intermediate medium; they may refer to internal communication between two elements or interaction between two elements. Unless otherwise explicitly defined, those skilled in the art can understand the specific meanings of the above terms in the present disclosure according to the specific context.

In the present disclosure, unless otherwise explicitly specified and defined, the first feature being "on" or "under" the second feature may mean that the first and second features are in direct contact, or that the first and second features are in indirect contact through an intermediate medium. Moreover, the first feature being "above", "over", or "on top of' the second feature may mean that the first feature is directly above or obliquely above the second feature, or merely indicates that a horizontal height of the first feature is higher than that of the second feature. The first feature being "below", "under", or "underneath" the second feature may mean that the first feature is directly below or obliquely below the second feature, or merely indicates that the horizontal height of the first feature is lower than that of the second feature.

It should be noted that if an element is referred to as "fixed to" or "disposed on" another element, it may be directly on the other element or a centered element may also be present. If an element is considered to be "connected" to another element, it may be directly connected to the other element or a centering element may also be present. When present, the terms "vertical," "horizontal," "upper," "lower," "left," "right," and similar expressions used herein are for illustrative purposes only and are not intended to be the only embodiments.

It should be understood that, a photovoltaic solar cell is a device that converts light energy into electrical energy. Specifically, the solar cell utilizes the photovoltaic effect to generate charge carriers, which are then extracted via electrodes to facilitate effective utilization of electrical energy. Currently, conventional photovoltaic modules employ a series-parallel configuration and use a three-part junction box to draw out the circuit while also serving a bypass function.

The photovoltaic modules are divided into single-glass and double-glass modules. For the double-glass modules, power output can be increased by applying a gap film to the back glass. For some modules with special functions or designed for specific application scenarios, interconnecting ribbons are required between cell strings to form electrical circuits. Currently, in conventional technologies, the cell strings are connected through bus bars. However, this method occupies space of the battery, reducing a light-receiving area of the battery cell, thereby affecting efficiency of the photovoltaic module. Additionally, the bus bars require isolation and insulation, making the process relatively complex and increasing the overall module cost.

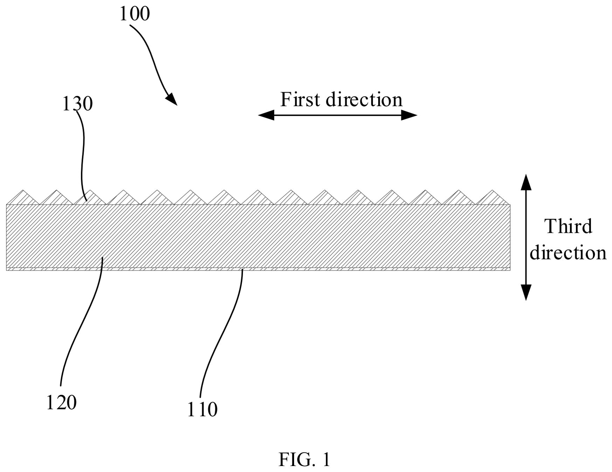

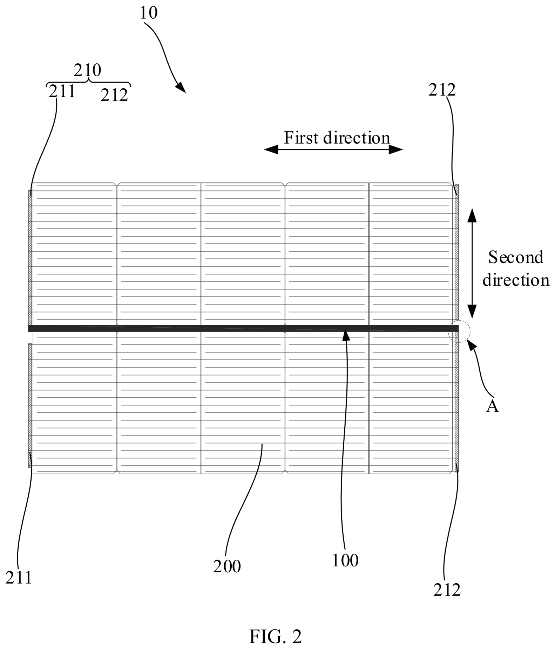

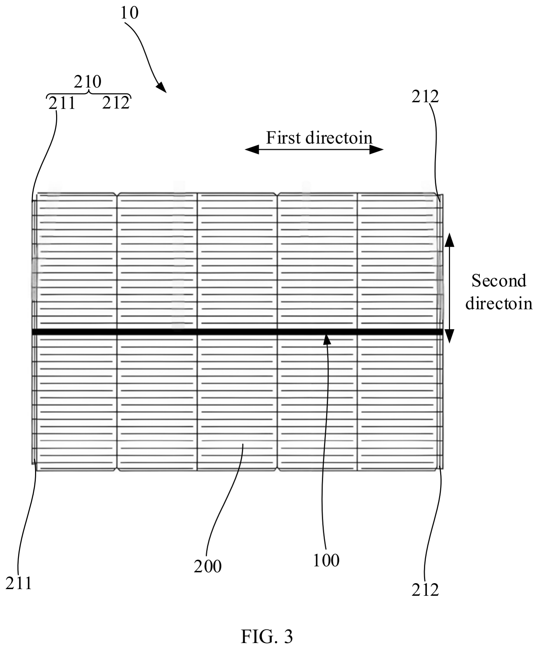

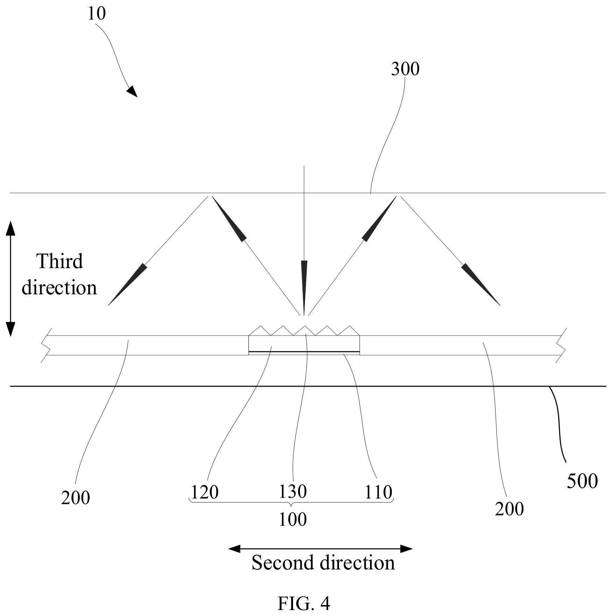

In view of above, referring to FIGS. 1 to 4, the present disclosure provides a novel combiner structure 100, which is applied to a photovoltaic module 10 to realize connection between two adjacent cell strings 200 in the photovoltaic module 10. FIG. 1 is a schematic diagram of a combiner structure 100 according to an embodiment of the present disclosure. FIG. 2 is a schematic diagram of an embodiment of connecting two cell strings by the combiner structure shown in FIG. 1. FIG. 3 is a schematic diagram of another embodiment of connecting two cell strings by the combiner structure shown in FIG. 1. FIG. 4 is a schematic diagram of light reflection by the combiner structure shown in FIG. 1.

In order to better explain the specific structure of the combiner structure 100, a structure of a photovoltaic module 10 will be briefly introduced here. The photovoltaic module 10 includes a cover glass 300, a backsheet 500 and a plurality of cell strings 200. The plurality of cell strings 200 are provided between the cover glass 300 and the backsheet 500, and the plurality of cell strings 200 are protected by the cover glass 300 and the backsheet 500. Furthermore, light is incident on surfaces of the plurality of cell strings 200 through the cover glass 300, so that the cell strings 200 can utilize the photovoltaic effect to generate charge carriers and output electric energy.

The cell string 200 includes a plurality of cells (not shown) and a welding ribbon (not shown), and the plurality of cell strings 200 are connected in series by the welding ribbon to form the cell string 200. As shown in FIGS. 1, 2, and 3, the cell string 200 extends along a first direction and a second direction. The cell string 200 has a certain length along the first direction and a certain width along the second direction, and the cell string 200 also has a certain thickness along a third direction, as shown in FIGS. 1 and 4.

The photovoltaic module 10 is generally provided with a plurality of cell strings 200, each of which extends in the first direction, and the plurality of cell strings 200 are spaced apart in the second direction. In the present disclosure, a connection relationship between the combiner structure 100 and cell strings 200 adjacent thereto is described only with two cell strings 200, and when a quantity of cell strings 200 is more than two, the connection principle is substantially the same as that of two cell strings 200, and the description thereof will not be repeated in the present disclosure.

In the present disclosure, the combiner structure 100 is provided between two cell strings 200, and the combiner structure 100 fills a gap between the two cell strings 200. That is, in the present disclosure, the combiner structure 100 is provided in the gap between two adjacent cell strings 200, and the combiner structure 100 covers the gap between the two cell strings 200 along the first direction and the second direction.

The combiner structure 100 has a reflective function. As shown in FIG. 4, when external light is incident on the cell string 200 through the cover glass 300, the cell string 200 can utilize the photovoltaic effect to generate charge carriers and output electric energy. Obviously, since there is a gap between the adjacent cell strings 200, a portion of light will inevitably be projected in the gap.

Accordingly, the combiner structure 100 between two adjacent cell strings 200 can reflect the light incident on the combiner structure 100, and the light is reflected to a back surface of the cover glass 300, and then reflected to surfaces of the cell strings 200 through the back surface of the cover glass 300. Finally, the cell strings 200 can process the light reflected from the back surface of the cover glass 300.

Thus, after the combiner structure 100 is provided between the adjacent cell strings 200, the combiner structure 100 can reflect the light incident in the gap between the two adjacent cell strings 200 to prevent the light from being projected away from the gap between the two adjacent cell strings 200, thereby avoiding waste of light energy and improving light energy utilization efficiency.

Additionally, the combiner structure 100 can also be electrically connected to two adjacent cell strings 200 to play role of a jumper wire, so that the two adjacent cell strings 200 can be connected to a circuit. Thus, the combiner structure 100 can connect two adjacent cell strings 200 in series, parallel, or the like, so that the two adjacent cell strings 200 can realize corresponding functions in the circuit.

In the present disclosure, the combiner structure 100 is provided in the gap between two cell strings 200. Both side edges of the cell string 200 are provided with bus bars 210, so that the combiner structure 100 can be electrically connected to the bus bar 210 of a preceding cell string 200 and can also be electrically connected to the bus bar 210 of a next cell string 200, playing a role of a jumper wire.

Thus, after the combiner structure 100 is electrically connected the two adjacent cell strings 200, the combiner structure 100 will not shield the cell strings 200, and at the same time, there is no need to increase the space between the two adjacent cell strings 200, thereby ensuring enough light-receiving area of the cell strings 200. Moreover, since the combiner structure 100 does not occupy the space of the cell strings 200, more cell strings 200 may be set in a limited space, thereby improving the efficiency of the photovoltaic module 10.

That is to say, after the combiner structure 100 of the present disclosure is provided in the gap between two adjacent cell strings 200, light incident in the gap between the two adjacent cell strings 200 may be reflected by the combiner structure 100, thereby improving the light energy utilization efficiency. At the same time, the combiner structure 100 can also be electrically connected to the two adjacent cell strings 200, ensuring the light-receiving area of the cell strings 200 to be large enough, and improving the efficiency of the photovoltaic module.

The combiner structure 100 of the present disclosure is provided in the gap between two adjacent cell strings 200 of the photovoltaic module 10 and can be electrically connected to the two adjacent cell strings 200, so that shading on the cell strings 200 may be reduced, thereby avoiding that the combiner structure 100 occupies an internal space of the photovoltaic module 10 and improving efficiency of the photovoltaic module 10. At the same time, the light incident in the gap between the two adjacent cell strings 200 may be reflected by the combiner structure 100, so that the light utilization efficiency may be improved, which further improves the efficiency of the photovoltaic module 10.

A specific structure of the combiner structure 100 according to an embodiment will be introduced in the following.

Referring to FIGS. 1 to 4. In an embodiment, the combiner structure 100 includes an adhesive layer 110, a conductive layer 120, and a reflective layer 130. The adhesive layer 110 is adhered and fixed to a backsheet 500 of the photovoltaic module 10. The conductive layer 120 is disposed on the adhesive layer 110 and is electrically connected to bus bars 210 of two adjacent cell strings 200. The reflective layer 130 is disposed on the conductive layer 120 and is used to reflect light incident on the combiner structure 100.

Taking the up and down direction shown in FIG. 1 as the reference, the conductive layer 120 is disposed on the adhesive layer 110, and the reflective layer 130 is disposed on the conductive layer 120. That is, the adhesive layer 110 is a bottom layer, the reflective layer 130 is a top layer, and the conductive layer 120 is a middle layer. Furthermore, an outer surface of the reflective layer 130 faces a cover glass 300, and an outer surface of the adhesive layer 110 faces the backsheet 500.

Thus, after the combiner structure 100 is provided between two adjacent cell strings 200, the adhesive layer 110 of the combiner structure 100 is bonded and fixed to the backsheet 500, so that the combiner structure 100 is reliably fixed to the backsheet 500, thereby avoiding displacement or shaking of the combiner structure 100, and ensuring that the combiner structure 100 is accurately located between the two adjacent cell strings 200.

When light passes through the cover glass 300 and irradiates the photovoltaic module 10, a portion of light will fall on the reflective layer 130 of the combiner structure 100. At this time, the reflective layer 130 can reflect the light to a back surface (a lower surface) of the cover glass 300, and then the back surface of the cover glass 300 reflects the light to the surfaces of the cell strings 200, thereby improving light energy utilization efficiency.

The combiner structure 100 between the two cell strings 200 is electrically connected to the bus bar 210 located at the edge of the cell string 200 through the conductive layer 120, which functions as a jumper wire to connect the cell string 200 to the circuit. Thus, since the combiner structure 100 is located in the gap between the two cell strings 200, the cell strings 200 will not be shielded and the space for the cell strings 200 will not be occupied, thereby ensuring enough light-receiving area of the cell strings 200 and improving the efficiency of the photovoltaic module 10.

Meanwhile, since the conductive layer 120 is electrically conductive, the arrangement of the adhesive layer 110 below the conductive layer 120 enables a lower surface of the combiner structure 100 to be electrically insulated. Thus, insulation can be realized by the adhesive layer 110 of the combiner structure 100 itself, eliminating the need for an additional insulation process for the combiner structure 100, thereby reducing operational complexity and lowering the production cost of the photovoltaic module 10.

In the combiner structure 100 of the above embodiments, the conductive layer 120 is provided on the adhesive layer 110, and the reflective layer 130 is provided on the conductive layer 120, so that the combiner structure 100 is fixed to the backsheet 500 of the photovoltaic module 10 by the adhesive layer 110, and the combiner structure 100 is reliably fixed between two adjacent cell strings 200 without need for the additional insulation process for the combiner structure 100, thereby reducing the manufacturing complexity and the cost. Furthermore, the combiner structure 100 is provided in the gap between two adjacent cell strings 200 of the photovoltaic module 10, electrically connected to the two adjacent cell strings 200 through the conductive layer 120, thereby reducing the shading on the cell strings 200, avoiding the occupation of an internal space by the combiner structure 100 in the photovoltaic module 10, and increasing the efficiency of the photovoltaic module. Meanwhile, by reflecting light incident in the gap between the two adjacent cell strings 200 through the reflective layer 130, light utilization efficiency is improved, thereby further improving the efficiency of the photovoltaic module 10.

Referring to FIG. 1 and FIG. 4, in an embodiment, the reflective layer 130 includes a plurality of projections 131. The plurality of projections 131 are sequentially arranged along the first direction of the combiner structure 100, and the projections 131 are used to reflect light. When light are incident on the gap between the two adjacent cell strings 200, the light can be projected onto the projections 131 of the reflective layer 130, and the projections 131 can reflect the light to the back surface of the cover glass 300, and then the light is reflected to the surfaces of the cell strings 200 through the back surface of the cover glass 300, thereby improving the light utilization efficiency.

In an embodiment, the projection 131 is provided with an inclined surface. Thus, after the light is incident on the projection 131, the inclined surface can reflect the light to the back surface of the cover glass 300 in an oblique direction, thereby allowing the light to be reflected to the surfaces of the cell strings 200.

In this embodiment, the projection 131 is a taper projection. That is, the projection 131 has a plurality of inclined surfaces. For example, the projection 131 may be a triangular pyramid, a quadrangular pyramid, or the like, to reflect light to a greater extent to the surfaces of the cell strings 200, ensuring the reflection effect of the light. In other embodiments of the present disclosure, the projection 131 may also have an inclined plane. Alternatively, the projection 131 may be a cone.

Obviously, in other embodiments of the present disclosure, the projection 131 may also be provided with an arched surface. Alternatively, a plurality of recesses may be provided on the surface of the reflective layer 130. A plurality of projections 131 may be formed on the surface of the reflective layer 130 by the plurality of recesses, as long as they can reflect light obliquely.

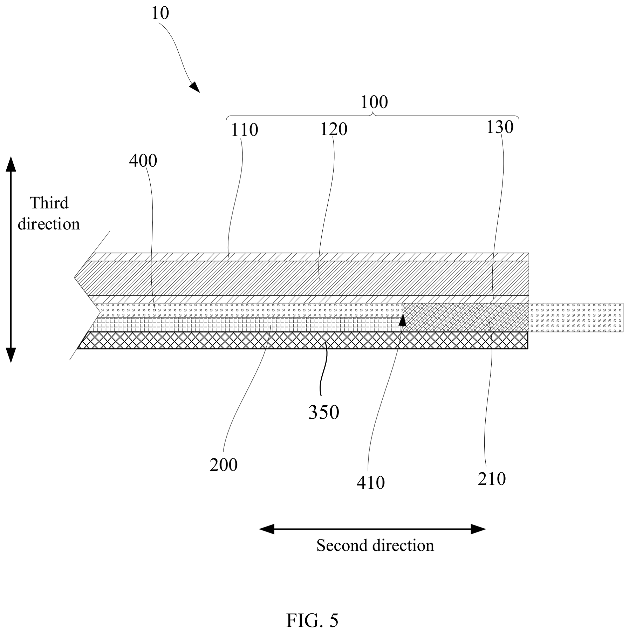

Referring to FIGS. 1, 4, and 5, in an embodiment, the reflective layer 130 is made of a conductive material and is welded to the bus bars 210 of adjacent cell strings 200. FIG. 5 is a schematic diagram of an embodiment of connection between the combiner structure 100 shown in FIG. 1 and a cell string 200.

That is, the reflective layer 130 has a conductive effect in addition to being capable of reflecting light. As shown in FIG. 5, the reflective layer 130 is adhered to the conductive layer 120 and the bus bars 210. When the combiner structure 100 is electrically connected to the bus bars 210 of the cell strings 200, the reflective layer 130 may be welded to the bus bars 210, so that the conductive layer 120 is electrically connected to the bus bar 210 through the reflective layer 130, and then the conductive layer 120 connects the cell strings 200 to the circuit.

In an embodiment, the reflective layer 130 is made of a metal material such as aluminum. The reflective effect of the reflective layer 130 is thereby ensured, while the conductive layer 120 of the combiner structure 100 can be electrically connected to the bus bars 210 of the cell strings 200 through the reflective layer 130. Obviously, in other embodiments of the present disclosure, the reflective layer 130 may also be made of other materials that can reflect light and conduct electricity.

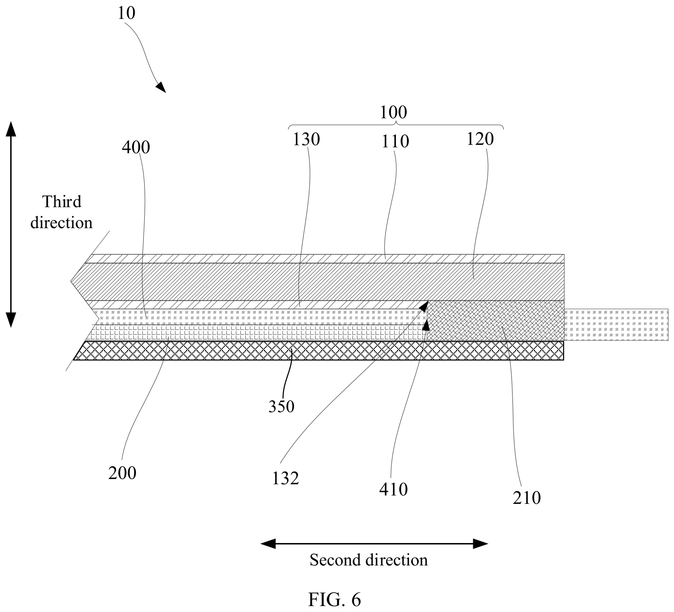

Referring to FIGS. 1, 4, and 6, in one embodiment, that is, in another embodiment of the present disclosure, the reflective layer 130 is made of a non-conductive material, and the reflective layer 130 is provided with a preset welding area 132 at a position corresponding to the bus bar 210 of the cell string 200. The preset welding area 132 is configured to expose the conductive layer 120, and the conductive layer 120 is electrically connected to the bus bar 210 through the preset welding area 132. FIG. 6 is a schematic diagram of another embodiment of the connection between the combiner structure 100 shown in FIG. 1 and a cell string 200.

In this embodiment, the reflective layer 130 can only reflect light and cannot conduct electricity. That is, the reflective layer 130 has an insulating effect. If the combiner structure 100 connects the bus bar 210 of the cell string 200 through the reflective layer 130, then the combiner structure 100 and the cell string 200 cannot be electrically connected.

As shown in FIG. 6, the preset welding area 132 is provided at a position of the reflective layer 130 corresponding to the bus bar 210 of the cell string 200. This preset welding area 132 can expose the conductive layer 120 relative to the reflective layer 130, that is to say, the preset welding area 132 is provided as a missing part of the reflective layer 130 at a position corresponding to the bus bar 210 of the cell string 200, and the preset welding area 132 can expose the conductive layer 120 from the reflective layer 130.

When the combiner structure 100 is electrically connected to the bus bar 210 of the cell string 200, the preset welding area 132 of the reflective layer 130 is aligned with the bus bar 210 of the cell string 200. At this time, the conductive layer 120 of the combiner structure 100 can be directly electrically connected to the bus bar 210 of the cell string 200 to allow the conductive layer 120 to connect the cell string 200 to the circuit.

In an embodiment, the reflective layer 130 is made of a reflective film of polyethylene terephthalate (PET) or a reflective coating or other materials. Thus, the reflective effect of the reflective layer 130 can be ensured, while the conductive layer 120 is also electrically insulated.

In an embodiment, the adhesive layer 110 is physically bonded to the backsheet 500 by glue, or the adhesive layer 110 is bonded to the backsheet 500 by silicone. Thus, the adhesive layer 110 can be reliably fixed to the backsheet 500 through an adhesive method, preventing the position of the combiner structure 100 from shifting relative to the backsheet 500, so that the adhesive layer 110 can be reliably positioned between adjacent cell strings 200.

In an embodiment, the reflective layer 130 is connected to the conductive layer 120 by adhesive bonding, heating, or coating. That is to say, a connection relationship is formed between the reflective layer 130 and the conductive layer 120 through methods such as bonding, heating, or coating to ensure the reliability of the connection between the reflective layer 130 and the conductive layer 120, and to prevent the reflective layer 130 and the conductive layer 120 from separating during the combiner structure 100 operates.

In an embodiment, the conductive layer 120 is made of a conductive material. Thus, the conductive performance of the conductive layer 120 may be ensured by the conductive material. After the conductive layer 120 is electrically connected to the bus bars 210 of the two adjacent cell strings 200, the conductive layer 120 can connect the two cell strings 200 to the circuit. In an embodiment, the conductive layer 120 is made of a conductive material such as copper, silver, or gold to ensure the conductive performance of the conductive layer 120.

In other embodiments of the present disclosure, the conductive layer 120 may also be made of a superconducting material. Thus, the conductive performance of the conductive layer 120 may be ensured by the superconducting material. After the conductive layer 120 is electrically connected to the bus bars 210 of the two adjacent cell strings 200, the conductive layer 120 can connect the two cell strings 200 to the circuit. In an embodiment, the conductive layer 120 is made of a superconducting material such as titanium, niobium, tin, copper, or bismuth to ensure the conductive performance of the conductive layer 120.

In an embodiment, a length of the combiner structure 100 along the first direction is adapted to a length of the cell string 200 along the first direction. Thus, the combiner structure 100 can be connected to the bus bars 210 of the two adjacent cell strings 200 in the gap between the two adjacent cell strings 200 to achieve a jump connection of the two adjacent cell strings 200.

In an embodiment, a width of the combiner structure 100 in the second direction ranges from 2 mm to 12 mm. With the width of the combiner structure 100 along the second direction being within the above range, the combiner structure 100 can cover the gap of two adjacent cell strings 200 along the second direction to ensure the light reflection effect. Meanwhile, it can also make the layout of each cell string 200 compact to arrange more cell strings 200 in a limited space.

In an embodiment, a thickness of the combiner structure 100 in the third direction ranges from 0.1 mm to 0.5 mm. Thus, with the thickness of the combiner structure 100 in the third direction being within the above range, the combiner structure 100 can be connected to the bus bars 210 of the two adjacent cell strings 200 in the gap between the two adjacent cell strings 200, thereby reducing the space occupied by the combiner structure 100 in the third direction and the height of the entire photovoltaic module 10.

The combiner structure 100 of the present disclosure is disposed in the gap between two adjacent cell strings 200 in the photovoltaic module 10, and the combiner structure 100 is electrically connected to the bus bars 210 of the two adjacent cell strings 200 through the conductive layer 120 to achieve the jump connection of the two adjacent cell strings 200, so that the two adjacent cell strings 200 are connected to the circuit. Thus, when the combiner structure 100 is electrically connected to the adjacent cell strings 200, the cell strings 200 ill not be shielded, ensuring the light-receiving area of the cell strings 200, and improving the efficiency of the photovoltaic module 10.

Meanwhile, with the reflective layer 130 provided on the conductive layer 120 of the combiner structure 100, the light incident on the combiner structure 100 is reflected by the reflective layer 130, so that the light is reflected to the surfaces of the cell strings 200 through the back surface of the cover glass 300, thereby reducing the waste of light energy and improving light energy utilization efficiency. Furthermore, with the adhesive layer 110 provided below the conductive layer 120 of the combiner structure 100, the adhesive layer 110 can be bonded to the backsheet 500 so that the combiner structure 100 is reliably fixed to the backsheet 500.

Thus, the combiner structure 100 arranged between the adjacent cell strings 200 is used as a reflective film to reflect light incident in the gap between the adjacent cell strings 200. Meanwhile, the combiner structure 100 can also function as a role of a connector. Therefore, the combiner structure 100 functions as both a gap coverage film and a jumper wire.

Referring to FIGS. 1 to 6, the present disclosure further provides a photovoltaic module 10, including a cover glass 300, a backsheet 500, a plurality of cell strings 200, a front adhesive film 350, a back adhesive film 400, and a plurality of combiner structures 100 as any of the above embodiments. The cover glass 300 is disposed above the backsheet 500. The plurality of cell strings 200 are provided between the cover glass 300 and the backsheet 500 and extend along a first direction and are spaced apart along a second direction.

The front adhesive film 350 is provided between the cover glass 300 and the plurality of cell strings 200, and the back adhesive film 400 is provided between the plurality of cell strings 200 and the backsheet 500. The combiner structure 100 is provided between the back adhesive film 400 and the backsheet 500 and extends along the first direction. The combiner structure 100 is disposed between two adjacent cell strings 200 and is electrically connected to bus bars 210 of the two adjacent cell strings 200.

The cover glass 300 is a glass cover plate for the front of the photovoltaic module 10, and the backsheet 500 is a back plate for the back of photovoltaic module 10. The cover glass 300 covers the backsheet 500, and the plurality of cell strings 200 are disposed between the cover glass 300 and the backsheet 500. The cover glass 300 and the backsheet 500 protect the cell strings 200 to ensure the performance of the cell strings 200.

Meanwhile, the front adhesive film 350 is disposed between the cover glass 300 and the cell strings 200, and the back adhesive film 400 is disposed between the cell strings 200 and the backsheet 500. The cell strings 200 are encapsulated and protected by the front adhesive film 350 and the back adhesive film 400. During the lamination process of the photovoltaic module 10, the front adhesive film 350 and the back adhesive film 400 provide a waterproof barrier and other protective function, ensuring the performance of the photovoltaic module 10.

Furthermore, the combiner structure 100 is disposed between any two adjacent cell strings 200 to be electrically connected to the bus bars 210 of adjacent cell strings 200, so that the adjacent cell strings 200 are connected to the circuit through the combiner structure 100. Moreover, the combiner structure 100 is disposed between the back adhesive film 400 and the backsheet 500, serving as a jumper wire while simultaneously reflecting light.

During a manufacturing process of the photovoltaic module 10 of the present disclosure, firstly, the front adhesive film 350 is laid on the back of the cover glass 300, then a plurality of cell strings 200 are laid on a surface, facing away from the cover glass 300, of the front adhesive film 350, and then the bus bars 210 are soldered to edges of the cell strings 200. After the welding of the bus bars 210 is completed, the back surface adhesive film 400 is laid on surfaces, facing away from the front adhesive film 350, of the cell strings 200.

After the laying of the back adhesive film 400 is completed, the welding of the combiner structure 100 is carried out. The combiner structure 100 is positioned between the back adhesive film 400 and the backsheet 500. The combiner structure 100 is welded with the bus bars 210 of the cell strings 200, and then the backsheet 500 is laid on the back adhesive film 400, while covering the combiner structure 100. Finally, the components are laminated to form a laminate, and the laminate is trimmed and inspected to form the photovoltaic module 10.

In an embodiment, a material of the backsheet 500 is composite panel or backsheet glass. When the material of backsheet 500 is the composite panel, the photovoltaic module 10 is a single glass module. When the material of backsheet 500 is the backsheet glass, the backsheet 500 is a double-glass module. In the present disclosure, the combiner structure 100 can be provided on the backsheet glass to prevent light from being emitted through the backsheet glass and improve light energy utilization efficiency. Obviously, the combiner structure 100 can also be provided on the composite plate.

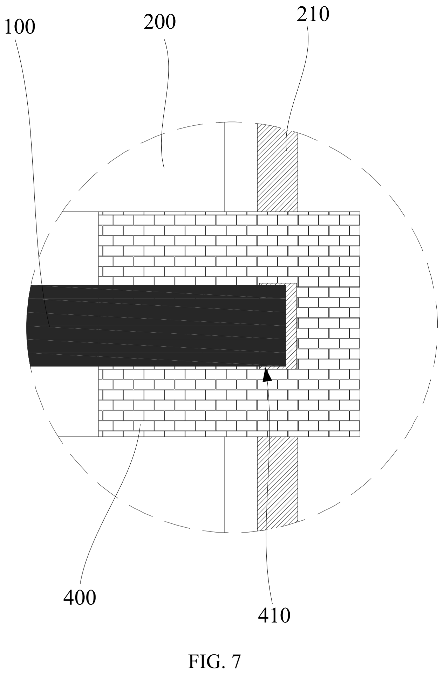

Referring to FIGS. 2, 5 to 7, in an embodiment, the back adhesive film 400 is provided with a hollow area 410 corresponding to the bus bar 210 of the cell string 200, and the combiner structure 100 is electrically connected to the bus bar 210 through the hollow area 410. FIG. 7 is a partial enlarged view of connection between the combiner structure shown in FIG. 2 and a cell string at A.

The back adhesive film 400 is an insulating adhesive film. In order to realize the electrical connection between the combiner structure 100 and the bus bars 210 of the cell strings 200, the hollow area 410 is provided in an area of the back adhesive film 400 corresponding to the bus bar 210 in the present disclosure, as shown in FIGS. 5 to 7. Thus, one end of the combiner structure 100 can be welded to the bus bars 210 of the cell strings 200 through the hollow area 410 to realize the electrical connection between the combiner structure 100 and the cell strings 200.

In an embodiment, the combiner structure 100 and the bus bars 210 of the cell strings 200 may be welded through processes such as laser welding, infrared welding, low temperature welding, and lamination welding to achieve reliable connection between the combiner structure 100 and the cell strings 200.

In an embodiment, the plurality of cell strings 200 are laid on the front adhesive film 350 after wired into strings. That is to say, a plurality of cells are welded into strings by solder strips first and then transferred to the front adhesive film 350 to be laid out. Obviously, in other embodiments of the present disclosure, the cell string 200 can be welded and connected on the front adhesive film 350. That is, the plurality of cells may be laid out as required on the front adhesive film 350 first, and then welded together by the solder strips to form the cell strings 200.

In an embodiment, the photovoltaic module 10 can be applied to battery technologies such as heterojunction cells (HJT cells), tunnel oxide passivated contact cells (TOPCon cells), back contact cells (BC cells), etc.

Referring to FIGS. 1, 2, and 4, in an embodiment of the present disclosure, each cell string 200 includes a first bus bar 211 and a second bus bar 212 with opposite polarities. The combiner structure 100 is electrically connected to the first bus bar 211 of a preceding cell string 200 and the second bus bar 212 of a next cell string 200 to make adjacent cell strings 200 connected in series.

Exemplarily, the first bus bar 211 may be a positive bus bar, and the second bus bar 212 may be a negative bus bar. Alternatively, the first bus bar 211 may be a negative bus bar, and the second bus bar 212 may be a positive bus bar. The first bus bar 211 and the second bus bar 212 are located at the edges of opposite sides of the cell string 200 along the first direction.

The combiner structure 100 of the present disclosure is connected to two bus bars 210, with opposite polarities, of adjacent cell strings 200 separately, connecting the two adjacent cell strings 200 in series. Specifically, one end of the combiner structure 100 is electrically connected to the first bus bar 211 of the preceding cell string 200, and the other end of the combiner structure 100 is electrically connected to the second bus bar 212 of the next cell string 200. Thus, the combiner structure 100 can serve as a jumper wire to connect adjacent cell strings 200 in series.

Referring to FIGS. 1, 3, and 4, in another embodiment of the present disclosure, each cell string 200 includes a first bus bar 211 and a second bus bar 212 with opposite polarities. The first bus bars 211 of adjacent cell strings 200 are connected and the second bus bars 212 of adjacent cell strings 200 are connected, so that the two adjacent cell strings 200 are connected in parallel. The photovoltaic module 10 may further include a junction box, which is configured to connect the first bus bars 211 of the plurality of cell strings 200 in series and the second bus bars 212 of the plurality of cell strings 200 in series, so that the first bus bars 211 and the second bus bars 212 are connected by the combiner structure 100 to allow the two adjacent cell strings 200 to be short-circuited under a preset condition.

In this embodiment, when adjacent cell strings 200 are connected in parallel, the first bus bar 211 of the preceding cell string 200 is electrically connected to the first bus bar 211 of the next cell string 200, and the second bus bar 212 of the preceding cell string 200 is electrically connected to the second bus bar 212 of the next cell string 200.

The combiner structure 100 is provided between two cell strings 200, with one end of the combiner structure 100 electrically connected to the first bus bars 211 and the other end connected to the second bus bars 212. Additionally, the junction box is connected in series between the first bus bar 211 and the second bus bar 212.

When the junction box is functioning normally, the photovoltaic module 10 can output current through the junction box. When the photovoltaic module 10 experiences a local hot spot effect, the combiner structure 100 can act as a protective measure to enable short-circuit connection between the parallel-connected cell strings 200, bypassing the hot spot area and ensuring the performance of the photovoltaic module 10.

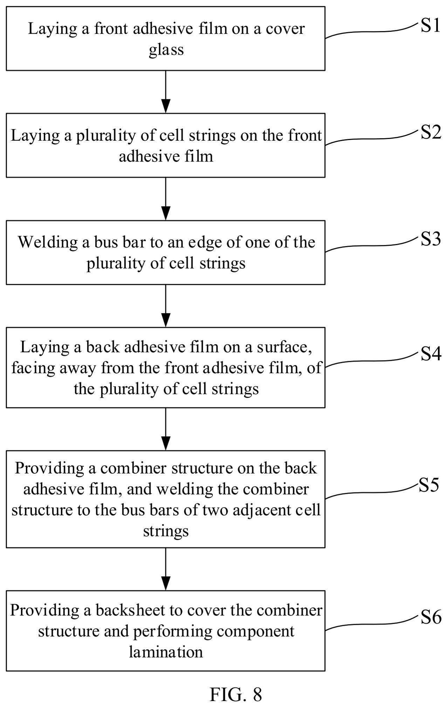

Referring to FIG. 8, FIG. 8 is a flowchart of manufacturing processes for a photovoltaic module according to an embodiment of the present disclosure. The present disclosure further provides a manufacturing method for a photovoltaic module 10, which is used to manufacture the photovoltaic module 10 of any of the above embodiments. The manufacturing method includes the following steps.

S1, laying a front adhesive film on a cover glass.

S2, laying a plurality of cell strings on the front adhesive film.

S3, welding a bus bar to an edge of one of the plurality of cell strings.

S4, laying a back adhesive film on a surface, facing away from the front adhesive film, of the plurality of cell strings.

S5, providing a combiner structure on the back surface adhesive film, and welding the combiner structure to the bus bars of two adjacent cell strings.

S6, providing a backsheet to cover the combiner structure and performing component lamination.

The photovoltaic module 10 of the present disclosure is manufactured by first laying the front adhesive film 350 on the back of the cover glass 300, then laying the plurality of cell strings 200 on a surface, facing away from the cover glass 300, of the front adhesive film 350, and then soldering bus bars 210 to edges of the cell strings 200. After the welding of the bus bars 210 is completed, a back surface adhesive film 400 is laid on the surface, facing away from the front adhesive film 350, of the cell string 200.

After the back adhesive film 400 is laid, the welding of the combiner structure 100 is carried out. The combiner structure 100 is positioned between the back adhesive film 400 and the backsheet 500. After the combiner structure 100 is welded with the bus bars 210 of the cell strings 200, the backsheet 500 is laid on the back adhesive film 400, while covering the combiner structure 100. Finally, the components are laminated to form a laminate, and the laminate is trimmed and inspected to form the photovoltaic module 10.

The technical features of the above-described embodiments can be arbitrarily combined, and all possible combinations of the technical features of the above-described embodiments have not been described in order to make the description concise, but as long as there is no contradiction between the combinations of the technical features, they should be considered to be within the scope of the present specification.

The above examples merely illustrate several embodiments of the present disclosure. The descriptions are specific and detailed, but this should not be understood as limiting the scope of the claimed patent. It should be noted that, for persons skilled in the art, various modifications and improvements can be made without departing from the concept of the present disclosure, and all of these fall within the scope of protection of the present disclosure. Therefore, the scope of protection of the patent of the present disclosure shall be determined by the appended claims.

## Claims

1. A combiner structure, provided between two adjacent cell strings (200) in a photovoltaic module (10), comprising:
an adhesive layer (110), adhered and fixed to a backsheet (500) of the photovoltaic module (10);
a conductive layer (120), disposed on the adhesive layer (110), electrically connected to bus bars (210) of the two adjacent cell strings (200); and
a reflective layer (130), disposed on the conductive layer (120), used for reflecting light incident on the combiner structure (100).

2. The combiner structure according to claim 1, wherein the reflective layer (130) comprises a plurality of projections (131) with inclined surfaces, the plurality of projections (131) being arranged sequentially along a first direction of the combiner structure (100), and the projections (131) being used for reflecting the light.

3. The combiner structure according to claim 2, wherein a shape of one of the plurality of projections (131) is any one of a two-sided pyramid, a three-sided pyramid, a four-sided pyramid; and a cone.

4. The combiner structure according to any one of claims 1 to 3, wherein the reflective layer (130) is made of a conductive material, and the reflective layer (130) is welded to the bus bars (210) of the two adjacent cell strings (200).

5. The combiner structure according to any one of claims 1 to 3, wherein the reflective layer (130) is made of a non-conductive material, the reflective layer (130) is provided with a preset welding area (132) corresponding to the bus bars (210) of the cell strings (200), and the preset welding area (132) is configured to expose the conductive layer (120), enabling the conductive layer (120) to be electrically connected to the bus bars (210) through the preset welding area (132).

6. The combiner structure according to any one of claims 1 to 5, wherein the conductive layer (120) is made of a conductive material or a superconducting material.

7. The combiner structure according to any one of claims 1 to 5, wherein the adhesive layer (110) is physically bonded to the backsheet (500) by glue, or the adhesive layer (110) is bonded to the backsheet (500) by silica gel.

8. The combiner structure according to any one of claims 1 to 5, wherein the reflective layer (130) is made of any one of an aluminum material, a polyethylene terephthalate reflective film, and a reflective coating.

9. The combiner structure according to any one of claims 1 to 8, wherein the reflective layer (130) is connected to the conductive layer (120) by adhesive bonding, heating, or coating; and/or, the conductive layer (120) is made of copper, silver, gold, titanium, niobium, tin, or bismuth.

10. The combiner structure according to any one of claims 1 to 9, wherein a width of the combiner structure (100) in a second direction ranges from 2 mm to 12 mm; and/or,
a thickness of the combiner structure (100) in a third direction ranges from 0.1 mm to 0.5 mm.

11. A photovoltaic module, comprising a cover glass (300), a backsheet (500), a plurality of cell strings (200), a front adhesive film (350), a back adhesive film (400), and a plurality of combiner structures (100) according to any one of claims 1 to 10;
wherein the cover glass (300) is disposed above the backsheet (500), and the plurality of cell strings (200) extend along a first direction and are spaced apart along a second direction between the cover glass (300) and the backsheet (500);
the front adhesive film (350) is disposed between the cover glass (300) and the plurality of cell strings (200), and the back adhesive film (400) is disposed between the plurality of cell strings (200) and the backsheet (500); and
the combiner structure (100) is disposed between the back adhesive film (400) and the backsheet (500) and extends along the first direction, and the combiner structure (100) is disposed between two adjacent cell strings (200) and electrically connects bus bars (210) of the two adjacent cell strings (200).

12. The photovoltaic module according to claim 11, wherein the bus bar (210) of each of the plurality of cell strings (200) comprises a first bus bar (211) and a second bus bar (212) with opposite polarities; and
the combiner structure (100) is electrically connected to the first bus bar (211) of a preceding cell string (200) and the second bus bar (212) of a next cell string (200) to make adjacent cell strings (200) connected in series.

13. The photovoltaic module according to claim 11, wherein the bus bar (210) of each of the plurality of cell strings (200) comprises a first bus bar (211) and a second bus bar (212) with opposite polarities;
the first bus bars (211) of the two adjacent cell strings (200) are connected and the second bus bars (212) of the two adjacent cell strings (200) are connected, so that the two adjacent cell strings (200) are connected in parallel; and
the photovoltaic module (10) further comprises a junction box, configured to connect the first bus bars (211) of the plurality of cell strings (200) in series and the second bus bars (212) of the plurality of cell strings (200) in series, so that the first bus bars (211) and the second bus bars (212) are connected by the combiner structure (100) to allow the two adjacent cell strings (200) to be short-circuited under a preset condition.

14. The photovoltaic module according to any one of claims 11 to 13, wherein the back adhesive film (400) is provided with a hollow area (410) corresponding to the bus bar (210) of one of the plurality of cell strings (200), and the combiner structure (100) is electrically connected to the bus bar (210) through the hollow area (410); and/or,
a material of the backsheet (500) is composite plate or backsheet glass.

15. A manufacturing method for a photovoltaic module (10) according to any one of claims 11 to 14, comprising:
laying a front adhesive film (350) on a cover glass (300);
laying a plurality of cell strings (200) on the front adhesive film (350);
welding a bus bar (210) to an edge of one of the plurality of cell strings (200);
laying a back adhesive film (400) on a surface, facing away from the front adhesive film (350), of the plurality of cell strings (200);
providing a combiner structure (100) on the back adhesive film (400), and welding the combiner structure (100) to the bus bars (210) of two adjacent cell strings (200); and
providing a backsheet (500) to cover the combiner structure (100) and performing component lamination.
